# EUROPEAN PATENT APPLICATION

(11) **EP 0 957 333 A1**
(43) Date of publication of application: **17.11.1999**
(21) Application number: 99303148.3
(22) Date of filing: 23.04.1999
(51) Int. Cl.: G01B 7/34, G01R 33/038

(54) **Correlation sample for scanning probe microscope and method of processing the correlation sample**

(30) Priority: 23.04.1998 JP 11380598
(71) Applicant: SEIKO INSTRUMENTS INC., Chiba-shi, Chiba 261 (JP)
(72) Inventor: Shirakawabe, Yoshiharu, Seiko Instruments Inc., Chiba-shi, Chiba (JP); Takahashi, Hiroshi, Seiko Instruments Inc., Chiba-shi, Chiba (JP); Shimizu, Nobuhiro, Seiko Instruments Inc., Chiba-shi, Chiba (JP); Yamaoka, Takehiro, Seiko Instruments Inc., Chiba-shi, Chiba (JP)
(74) Representative: Sturt, Clifford Mark

(57) **Abstract**

A correlation sample for a scanning probe microscope enabling correct detection of each force acting as a standard without any influence by irregular data from the surface of the sample. A photo-resist film is applied on a surface of a silicon substrate, and the resist mask is patterned. Hollow portions having a vertical wall face are formed in the silicon substrate by carrying out anisotropic etching using the resist mask. After that, metal is deposited using a deposition method, the metal above the resist mask is removed by a lift off process, and a correlation sample in which the metal is buried in the hollow portions of the silicon substrate is formed. The surface of the sample can be flattened by coating a DLC film on the surface of the correlation sample.

## Description

The present invention relates to a correlation sample for a scanning probe microscope and a method of processing the sample, particularly a correlation sample for a scanning probe microscope performing a standard of measurement in measuring a state of a surface of a sample and a method of processing the correlation sample.

In recent years, it has become possible to observe the irregular shape of the surface of a sample at an atomic level. That is, in an atomic force microscope for observing atomic structure, a cantilever having a tip at the head portion thereof has been used. When the tip is scanned over the surface of a sample consisting of a measured surface, an attraction or reaction is generated based on the atomic force between the surface of the sample and the tip, and the atomic force can be determined by detecting deflection of the cantilever.

The category of scanning probe microscopes includes: a magnetic force microscope which detects a magnetic force of the measured surface developed by application of the above-mentioned atomic force microscope (hereinafter, AFM); a scanning Maxwell stress microscope which detects the voltage and electrostatic force of the measured surface, and a Kelvin probe force microscope, such microscopes can detect force which can not be determined from the irregular data of the measured surface. The magnetic force microscope (hereinafter, MFM), the scanning Maxwell stress microscope (hereinafter, SMM), and the scanning Kelvin force microscope (hereinafter, KFM) can obtain the irregular data of the measured surface in high resolution similarly to the AFM. Additionally, irregular data and magnetic image data can be observed at the same domain and at the same time in the MFM, for example.

Therefore, compared with the conventional measuring and observing methods, the above-mentioned MFM, SMM, and KFM have various advantages such as high resolution, observation of surface shape at the same time as other data, and ease of obtaining data. Therefore, the field of application of these microscopes is increasing in domain analysis of magnetic media, analysis of magnetic materials, electric characteristics and failure analysis of semiconductors, and estimation of work functions in materials.

However, although relative comparison images of each force (N pole and S pole in magnetic force for example) can be obtained in the conventional scanning type probe microscope from the observation of an object, there has been a problem in that it has not been possible to obtain absolute values (magnetic strength for example) because of the lack of a measurement standard.

An AFM has recently been proposed which makes absolute measurements by preparing a correlation sample as a standard of height. However, there has been a problem that the measured value varies at each replacement of the microscope or sample because the sample is of one kind and the measured surface is measured with the sample as a standard.

No correlation sample of force acting as a standard has been prepared for MFM, SMM, and KFMs, it has only been done with the above-mentioned AFM. Accurate detection of the force of the measured surface using these microscopes needs measurement in a state in which the distance between the measured surface and the tip is always kept constant. However, it is difficult to detect the force distribution of a real correlation sample because of the influence of irregularities which appear in the measurement result when the surface is irregular. For example, an object (magnetic body and so on) generating force (magnetic force for example) and acting as a certain standard is located on the surface of a silicon and glass substrate so as to make a correlation sample and is used for the correlation sample by providing a measurement standard for high density magnetic media. However, the real force distribution above the sample can not be measured accurately because it is difficult to accurately keep the distance between the tip and the surface of the sample constant if measurement is attempted while moving the tip up and down so that the distance is kept constant.

To compensate for the above mentioned problem, it is considered that the result of force measurement of a sample surface is corrected based on the irregular data of the correlation sample previously obtained. However, force measurement by the cancellation system is not in practical use yet so as to obtain accurate measurement values.

The present invention has been made in view of the above-mentioned problems in the prior art. A first object of the present invention is to provide a scanning probe microscope in which each force acting as a standard is accurately detected without influence by the irregular data of the surface and such that the strength value of each force at measurement can be determined (absolute measurement) correlating the microscope using the detection and a method of processing the correlation sample.

A second object of the present invention is to provide a scanning probe microscope in which absolute measurements can be carried out accurately based on the irregular data and a method of processing the correlation sample.

To achieve the above-mentioned objects a first aspect of the invention includes a correlation sample of a scanning probe microscope for measuring the state of the surface of a sample, comprising a foreign domain where material having a physical constant differing from the material of a substrate is buried with a certain thickness in the in-plane direction of the substrate acting as a sample, wherein the surface of said substrate is flat.

As the foreign domain where material having a physical constant differing from the material of the substrate is buried with constant thickness in the in-plane direction of the substrate acting as a sample in which the surface of the substrate is flat, the present invention is not influenced by irregular data, and can purely and correctly detect each force acting as a standard so as to enable absolute measurements to be carried out in various kinds of scanning probe microscopes. A material having a physical constant different from the material of the substrate means is, for example, a magnetic body generating magnetic force acting as a standard in the case of a MFM and a material generating voltage and electrostatic force acting as a standard. These materials are buried in the substrate with a certain thickness in order to obtain enough thickness to detect the force depending on the materials, because the materials could not provide sufficient force for detection if the thickness of the buried material is thin.

A second aspect of the invention includes a method of processing a correlation sample of a scanning probe microscope for measuring a state of a surface of a sample comprising the steps of, forming holes of a certain depth having vertical walls relative to the surface of a substrate at a predetermined domain of the substrate acting as a sample, burying material having a physical constant differing from the material of said substrate into the said holes, and flattening the surface of the domain where the material differing in said physical constant from the said substrate is buried.

According to the present invention, holes of a certain depth having vertical walls relative to the surface of a substrate at a predetermined domain of the substrate are formed, material having a physical constant different from the material of the substrate is buried in the holes and the surface of the domain where the substrate is buried and the surface of the substrate are flattened. Therefore, the apparatus and method of the present invention is not influenced by irregular data, and can purely and correctly detect each force acting as a standard so as to enable absolute measurements to be carried out in various kinds of scanning probe microscopes.

The invention, according to the second aspect thereof, includes a correlation sample of a scanning probe microscope for measuring the state of a surface of a sample, comprising at least one of domains having plural different height standards in height and plural different width standards in width formed in the in-plane direction of the substrate acting as a sample.

According to the present invention, there is no need to worry about the change of measurement value if a sample or device is changed because absolute measurements can be carried out based on the result from comparing a plurality of different standards (height or width) formed on the same sample as at least one of domains of plural different height standards and plural different width standards. Thus, by forming plural height standards and a width standard comprising irregular data on the same sample, correct absolute measurements can be carried out. Here, the domain acting as height standards and a width standard means that accurate holes and projection portions in size are formed in the in-plane direction of the substrate and the distance between the bottom face, upper face, and side face is used as a standard.

The invention, according to a second aspect thereof, includes a method of processing a correlation sample of a scanning probe microscope for measuring a state of a surface of a sample comprising the steps of, forming at least one of domains of a first height standard and a first width standard at predetermined position of a substrate acting as a sample, and forming at least one of domains of a second height standard and a second width standard at a position of the substrate different from the first said domain.

According to the present invention, at least one of domains of a first height standard and a first width standard at a predetermined position of a substrate, and at least one of domains of a second height standard and a second width standard is formed at a position of substrate different from the first said domain. Thus, as plural standards are formed in a second process, the standard formed in the first process is not influenced by the second process so as to form plural standards correctly.

According to another aspect, the invention includes a correlation sample for a scanning probe microscope for measuring a state of a surface of a sample, comprising; a foreign domain where material having a physical constant differing from the material of a substrate is buried with constant thickness in the in-plane direction of the substrate acting as a sample, and at least one domain of height standard and width standard formed at a position of the substrate different from said foreign domain.

According to the present invention, as the foreign domain where the material having a physical constant differing from the material of the substrate is buried with a certain thickness in the in-plane direction of the substrate acting as a sample, and at least one domain of height standard and width standard formed at a position of the substrate differing from the foreign domain, a physical value acting as a standard with one sample and at least one of height standard and width standard are taken at the same time as a standard value.

According to another aspect, the invention provides a method of processing a correlation sample of a scanning probe microscope for measuring a state of a surface of a sample comprising the steps of, forming holes of a constant depth having vertical wall faces relative to the surface of a substrate at a predetermined domain of the substrate acting as a sample, forming at least one hole of height standard and width standard at a position of the substrate different from the first formed hole, selectively burying material having a physical constant different from the material of said substrate into the holes having said vertical wall faces, and flattening the surface of the domain where the material different in said physical constant from the said substrate is buried and flattening the surface of said substrate.

According to the present invention, holes of a certain depth having vertical wall faces relative to the surface of a substrate at a predetermined domain of the substrate are formed, at least one hole of height standard and width standard at a position of the substrate different from the first hole is formed, material having a physical constant different from the material of the substrate is buried, into the holes having the vertical wall faces, and the surface of the domain where the material different in the physical constant is buried and the surface of the substrate is flattened. Therefore, it is possible to form a physical constant acting as a sample and at least one of height standard and width standard are formed on one sample at the same time as a standard value.

According to another aspect, the invention provides a correlation sample of a scanning probe microscope according to certain of the above aspects, wherein a coating film having surface wear and abrasion resistance is formed on the surface of said formed correlation sample.

According to the present invention, as a coating film having surface wear and abrasion resistance is formed on the surface in the correlation sample, the surface of the sample is protected from the differences of frictional force caused by differences in the material of the substrate and the material of the foreign domain, oxidation, corrosion, charging up of the surface of the sample, adhesion of contaminants by charging up, flaws of the surface and asymmetric wear by the probe; so as to keep flatness.

According to another aspect, the invention provides a method of processing a correlation sample of a scanning probe microscope according to certain of the above aspects, further comprising the step of forming a coating film having surface wear and abrasion resistance on the surface of said formed correlation sample.

According to the present invention, as the process of coating a film having surface wear and abrasion resistance on the surface of the correlation sample is added, the surface of the sample is protected from differences in frictional force caused by differences between the material of the substrate and the material of the foreign domain, oxidation, corrosion, charging up of the surface of the sample, adhesion of contaminants by charging up, flaws in the surface and asymmetric wear by the probe; so as to keep flatness.

According to another aspect, the invention includes a correlation sample of a scanning probe microscope comprising, an electric resistor formed in a certain section of the surface of the substrate acting as a sample, and electrodes connected with said electric resistor at said surface of the substrate for enabling current flow to the electric resistor.

According to the present invention, as an electric resistor is formed with a certain depth from the surface of the substrate in a certain section of the surface of the substrate, and electrodes are connected with the electric resistor at the surface of the substrate for enabling current flow, the quantity of calorie of the electric resistor can be controlled depending on the quantity of current flowing through the electrodes. Therefore, a correlation sample enabling local heating for observing the interaction of heat and an image can be obtained.

The invention includes a method of processing a correlation sample of a scanning probe microscope comprising the steps of, forming an electric resistor in a certain section by covering the surface of the substrate except the certain section thereof; providing a semiconductor using an ion implantation mask and implanting impurity ions into a certain domain in the substrate, and forming an electrode material on at least two connecting portions connected with said electric resistor on said surface of the substrate.

According to the present invention, as the electric resistor is formed in a certain section by covering the surface of the substrate except the certain section thereof; a semiconductor is provided using an ion implantation mask and implanting impurity ions into a certain domain in the substrate, and the electrical resistor and the material of the electrodes are connected with at least two contacting portions, the quantity of calorie of the electric resistor can be controlled depending on the quantity of current flowing through the electrodes. Therefore, a correlation sample enabling local heating for observing the interaction of heat and an image can be obtained.

Embodiments of the present invention will now be described by way of further example only and with reference to the accompanying drawings, in which:-
Figs. 1A to 1G are sectional views showing a method of processing a correlation sample for detecting each force acting as a standard according to a first embodiment of the present invention.
Figs. 2A and 2B are sectional views showing a method of processing a correlation sample for detecting height and width acting as a standard according to a second embodiment of the present invention.
Figs. 3A to 3F are sectional views showing a method of processing a correlation sample for detecting height and width acting as a standard probe according to a third embodiment of the present invention.
Figs. 4A to 4L are sectional views showing a method of processing a correlation sample enabling local heating for observing the interaction between heat and an image according to a fourth embodiment of the present invention.
Fig. 5 is a plan view of Fig. 4D
Fig. 6 is a plan view of Fig. 4E
Fig. 7 is a plan view of Fig. 4G
Fig. 8 is a plan view of Fig. 4H
Fig. 9 is a plan view of Fig. 4I
Fig. 10 is a plan view of Fig. 4J
Fig. 11 is a plan view of Fig. 4K
Fig. 12 is a plan view of Fig. 4L
Fig. 13 is a plan view showing an example in which a heat sink metal pad is formed at the surface of the correlation sample of Fig. 12.

Referring to the figures, embodiments of correlation samples for scanning probe microscopes and of methods of processing the correlation samples according to the present invention will be described.

### (First Embodiment)

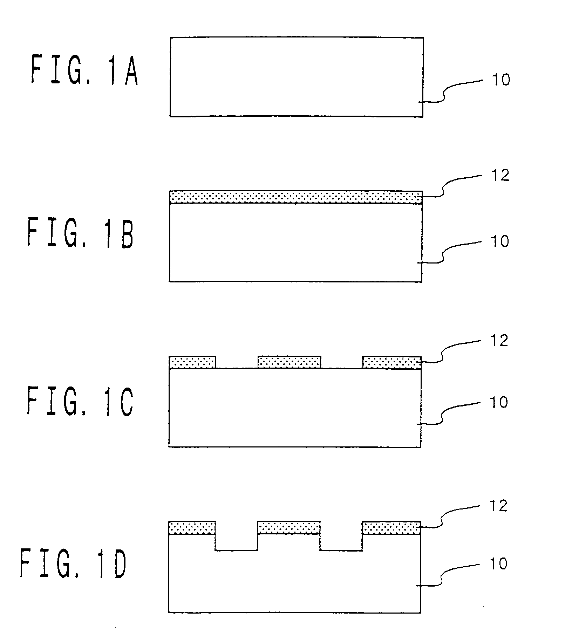

Figs. 1A to 1G are sectional views showing a method of processing a correlation sample for detecting each force acting as a standard according to a first embodiment. The correlation sample of the first embodiment functions as a standard when magnetic force, electrostatic force, and voltage of a surface are measured by a MFM, KFM, SMM, and so on.

First, a photo resist film 12 of a predetermined thickness is applied to a surface of a silicon substrate 10, as shown in Fig. 1A and Fig. 1B. The silicon substrate 10 is patterned so as to be completely covered except for parts removed by etching using a photo lithography process and the photo-resist film 12 (hereinafter resist mask) (Fig. 1C).

Next, anisotropic etching by reactive ion etching is carried out using the resist mask 12 on the silicon substrate 10, then the etching profile (side face) of a wall face of a hollow portion formed in the silicon substrate 10 is cut vertically as shown in Fig. 1D. The depth of the hollow portion can be controlled accurately by controlling the etching time. The etching conditions in this case are: use of (SF₆+O₂) gas for etchant; gas pressure is 10 pa; and output is 100 W.

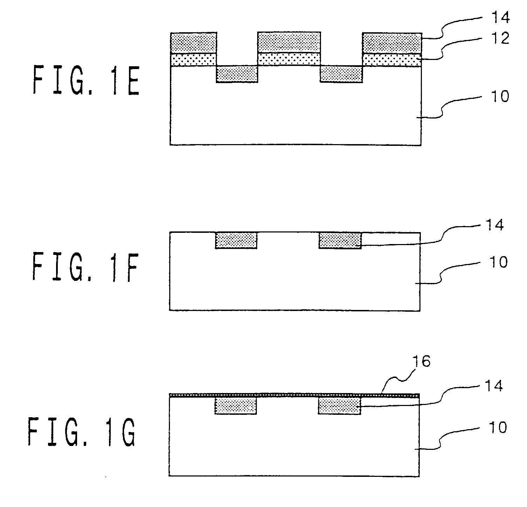

Next, metal 14 is deposited by multi-parallel electronic beam deposition over the remaining resist mask 12 as shown in Fig. 1E. Alloys such as (Fe-Ni) and (Pt-Co-Cr) and metals such as Co and Nb can be used. Although the deposition is usually by ohmic resistance heating if the deposition deposits only a single metal such as the above-mentioned Co and Nb for example, the deposition of an alloy is possible if multi-parallel electronic beam deposition is adopted.

When detecting magnetic force using a MFM, it is impossible to detect the magnetic force if the thickness of the film is too thin. It is preferable to coat a (Fe-Ni) film to a thickness of 20 nm for example. As the metal 14 is deposited thick and the sectional shape thereof is made rectangular as shown in Fig. 1E by forming a hollow portion using anisotropic etching as shown in Fig. 1D in the first embodiment; it is possible to obtain sufficient detection sensitivity using magnetic anisotropy. By changing the ratio of length to width (aspect ratio) and the thickness of the metal 14, the strength can be changed.

Although spattering is normally used for forming the above-mentioned multi metal film, the deposition process is adopted because spattering wraps around the wall face and the like and burrs can easily be formed at the edge portion when removing extra metal film in the next process stage using a lift off method. The deposit process has the characteristic that film is not formed in any shadow as seen from the deposit source (shadow effect). The metal can thus be deposited only at the hollow portion of the silicon substrate 10 by using the shadow effect. Burrs do not appear at the edge even after lift off in the next process stage.

After that, using a lift off process from the state shown in Fig. 1E, metal 14 existing above the resist mask 12 can be removed, and a correlation sample formed in which the metal 14 is buried in the hollow portion of the silicon substrate 10 as shown in Fig. 1F.

In the first embodiment, a diamond like carbon (DLC) film 16 (which has a low coefficient of friction, which is high in wear and abrasion resistance, and which can be thinly coated as a surface protecting film) is surface-coated at a thickness of about 5 to 10 nm using a CVD method, as shown in Fig. 1G. The coat of DLC film 16 can make the surface of the correlation sample very smooth, and can form a sample not having an irregular surface. The coat has the advantages that it does not cause any influence because of different frictional forces and it can protect the sample from oxidation, corrosion, charging up of the sample surface, and adhesion of contaminants by charging up.

In the first embodiment, although the extra metal 14 deposited in the step shown in Fig. 1E is removed by a lift off process, a similar sample as that of Fig. 1F may be formed by removing the extra metal 14 existing above the silicon substrate 10 using chemical polishing and mechanical polishing after removing the resist mask 12 in Fig. 1D and by depositing the metal 14. In that case too, the DLC film 16 may be surface-coated.

As above-mentioned, according to the first embodiment, a correlation sample acting as a standard for measuring magnetic force, electrostatic force, and voltage of the surface by a MFM, KFM, SMM, and so on and being smooth at the surface thereof can be obtained. As various materials of single metal such as Co and Nb and alloys such as (Fe-Ni) and (Pt-Co-Cr) can be used for the foreign material generating each force and which is buried in the substrate. The shape of the buried foreign material can be changed freely. Thus, the embodiment has the advantage of easily obtaining sensitivity and strength sufficient for detection. By surface-coating the DLC film and the like as a surface protecting film for the correlation sample, the surface of the sample becomes very smooth even if the surface of the sample comprises foreign materials. This removes any influence which might otherwise arise due to different frictional forces. Moreover, the embodiment can protect the sample from oxidation, corrosion, charging up of the sample surface, and adhesion of contaminants by charging up.

### (Second Embodiment)

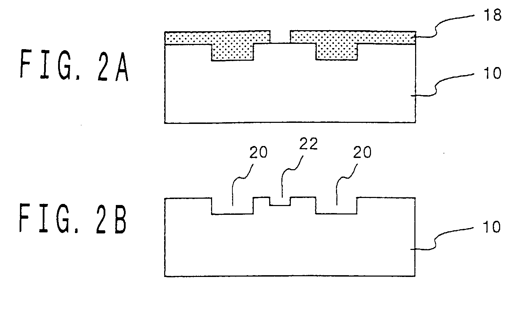

Figs. 2A and 2B are sectional views showing the manufacturing method of a correlation sample to detect height and width acting as a standard according to the second embodiment of the invention. The correlation sample of the second embodiment becomes a standard for measuring height and width with an AFM. The manufacturing processes before Fig. 2A are the same as in Figs. 1A to 1D above-mentioned.

Namely, the hollow portion formed in the silicon substrate 10 of Fig. 1D is a sample acting as a first standard of height and width. After the resist mask 12 on the silicon substrate 10 shown in Fig. 1D is removed, photo-resist is again applied on the whole of the substrate and a resist mask 18 covering the surface of the substrate except for a small part is patterned using a photo lithography technique, as shown in Fig. 2A.

By carrying out anisotropic etching with reactive ion etching using the resist mask 18 for an etching mask, a hollow portion 22 acting as a second standard of height and width is formed as shown in Fig. 2B. The etching profile (side face) of the wall face of the hollow portion 22 too is etched vertically similarly as the portions 20. The depth of the hollow portion 22 can be controlled accurately by changing the etching time. The etching condition in this case is similar to that for forming the hollow portions 20: using (SF₆+O₂) gas; gas pressure is 10 pa; and output of etching ion is 100 W. Changing only the etching time, samples of different height are formed correctly on the same substrate.

The hollow portions 20 and 22 provide samples different in width at the same time, and these widths can be determined freely by changing the size of the etching mask.

Thus, according to the second embodiment, a correlation sample having a standard measuring height and width for an AFM can be formed. As the correlation sample compares plural standards measuring the same sample with the same condition because of having different height standards and width standards in one sample, it is possible to carry out absolute measurements correctly based on comparison so that differences in the result of the measurement hardly appear even if the sample and device differ from others used.

### (Third Embodiment)

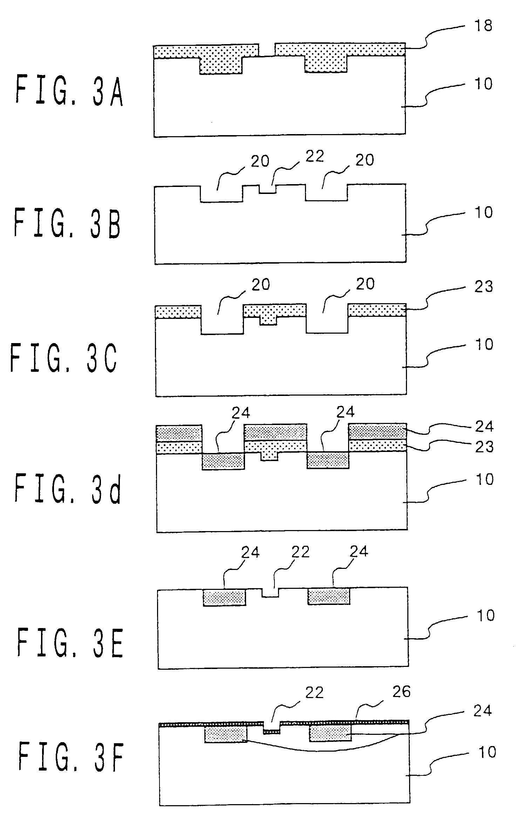

In Figs. 3A to 3F are sectional views of the method of manufacturing a correlation sample to detect height and width acting as a standard according to the third embodiment of the invention. The correlation sample of the third embodiment becomes a standard for measuring height and width using a MFM, KFM, SMM, and so on. The manufacturing processes prior to Fig. 3A are the same as in Figs. 1A to 1D as above mentioned.

First, after the resist mark 12 on the silicon substrate 10 shown in Fig. 1D is removed, photo-resist is again applied on the whole of the substrate and a resist mask 18 covering the surface of the substrate except for a small part is patterned as shown in Fig. 3A.

Then, by removing the resist mask 18 after anisotropic etching with reactive ion etching using the resist mask 18 for an etching mask, a hollow portion 20 for burying materials different in physical constant and a hollow portion 22 acting as a standard of height are formed as shown in Fig. 3B. The etching profile (side face) of the wall face of the hollow portions 20 and 22 are etched vertically, and the depth of the hollow portions can be controlled accurately by changing the etching time. The etching condition in this case is similar to that for forming the hollow portions 20: using (SF₆+O₂) gas; gas pressure is 10 pa; and output of etching ion is 100 W.

After applying photo-resist on the whole of the substrate, a resist film 23 for use in the lift off process is formed on the surface of the silicon substrate 10 except in the hollow portions 20 is patterned as shown in Fig. 3C.

Metal 24 is deposited on the upper side of the resist film 23 by parallel multi electron beam deposition as shown in Fig. 3D. The material of the metal 14 can be, for example, Co, Nb, and alloy such as (Fe0Ni), (Pt-Co-Cr), and so on. As above-mentioned, a deposition process is adopted for burying material (metal 24) of different physical constant in the hollow portions 20. Therefore, there is practically no wrapping around the wall face and burrs do not appear at the edge portion even when the metal above the resist film 23 is removed using a lift off process in the next process step.

By melting the resist film 23 from the state shown in Fig. 3D and using a lift off process for removing the metal 24 above the resist film 23, the metal 24 is buried in the hollow portions 20 of the silicon substrate 10, and a correlation sample in which a hollow portion 22 acting as a standard of height is formed at the same time.

In the third embodiment, a DLC film 26 for forming a surface protecting film is surface-coated with a thickness of about 5 to 10 nm by a CVD method as shown in Fig. 3F. Therefore, the surface of the correlation sample can be made very smooth. It avoids any influence due to different frictional forces, and can protect the sample from oxidation, corrosion, charging up of the sample surface, and adhesion of contaminants by charging up; even if the materials constituting the surface such as the silicon substrate 10 and the metal 24 are different from each other.

In the third embodiment, extra metal 24 and the like may be removed using chemical polishing and mechanical polishing instead of the lift off process, similarly as mentioned in the first embodiment.

Thus, according to the third embodiment, a complex sample is provided having a correctional sample acting as a standard for measurement of magnetic force, electrostatic force, and voltage of the surface for a MFM, KFM, SMM, and so on. A correlation sample acting as a standard of height for an AFM and the like is provided. Various materials of single metal such as Co and Nb and alloys such as (Fe-Ni) and (Pt-Co-Cr) can be used for the foreign material buried in the substrate and the shape of the buried foreign material can be changed freely. The embodiment has the advantage of easily obtaining sufficient sensitivity and strength to enable detection. By coating the surface of the sample with a thin film such as a DLC film with a low coefficient of friction, the surface of the sample becomes very smooth so as to remove any influence which might be caused by differences in frictional force. Moreover, the embodiment can protect the sample from oxidation, corrosion, charging up of the sample surface, and adhesion of contaminants by charging up.

### (Fourth Embodiment)

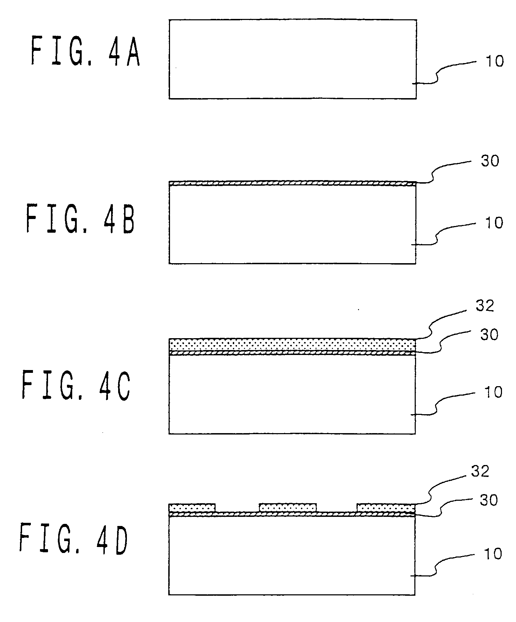

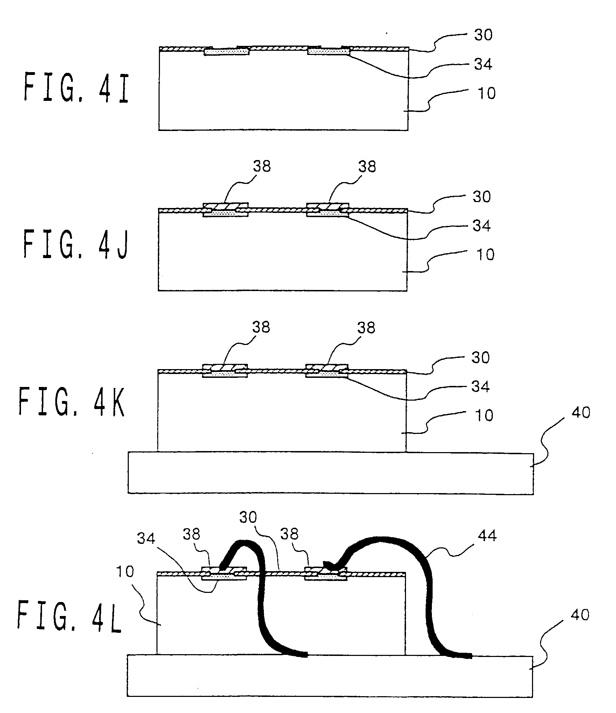

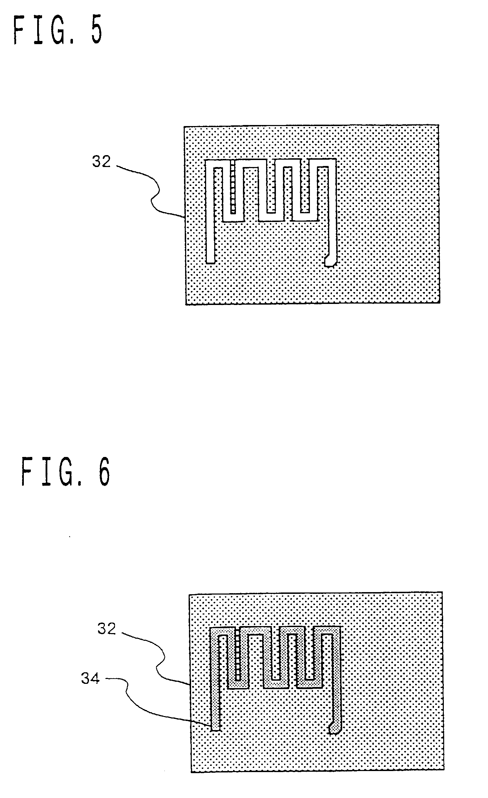

Fig. 4A to Fig. 13 show a method of processing a correlation sample in which local heating is provided for observing the interaction of heat and an image according to the fourth embodiment of the invention. Figs. 4A to 4L show sectional views and Figs. 5 to 13 show plan views corresponding to the sectional views of Figs. 4A to 4L. The correlation sample of the fourth embodiment can provide local heating for observing the interaction of heat and an image in all measuring modes.

First, by thermal oxidation of the surface of a silicon substrate (Si) as shown in Fig. 4A, oxidation film (SiO₂) 30 having a thickness of about several hundred angstrom is formed as shown in Fig. 4B. The oxidation film 30 is formed in order to prevent the surface of the silicon substrate 10 from becoming rough during the ion implantation described later.

In Fig. 4C, a photo-resist film 32 is applied on the oxidation film (SiO₂) 30, and is patterned so as to cover the surface except for a part forming a resistor for heating in the silicon substrate 10 after the photo lithography process covers the surface with the resist mask 32 (Fig. 4D). Therefore, the resist mask 32 is an ion implantation mask. Fig. 5 is a plan view of the patterning shape of the resist mask 32 in Fig. 4D seen from above. The white portion shows the part not covered with the resist mask 32.

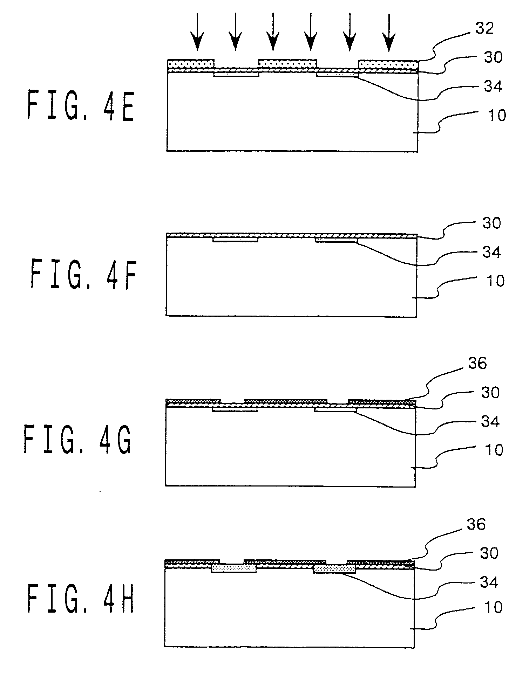

Fig. 4E shows ion implantation to the silicon substrate 10 using impurity ions such as boron (B), phosphorus (P), and so on. By adding a little of the above impurity into the silicon substrate for forming a semiconductor, the ion implantation process is carried out in order to form a domain having a certain conductivity (here, the resistor of the heater portion). The electric resistance of the conductive domain formed in the substrate can be adjusted depending on the ion concentration implanted. Although the ion implanted is B and the ion impurity is 15E15 atm/cm² here, the invention is not limited by these values. The B ion implanted in the substrate forms ion implantation portions 34 near the surface of the silicon substrate 10. The ion implantation portions 34 can become a resistor having a constant resistance by activation using annealing. Fig. 6 is a plan view of the shape of the ion implantation portion 34 in Fig. 4E seen from above.

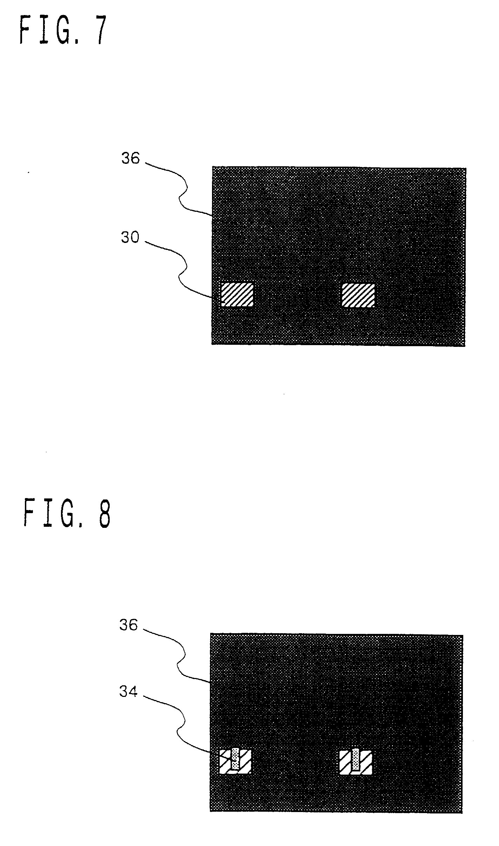

After the resist mask 32 is removed as shown in Fig. 4F, a photo-resist film 36 is applied to the whole of the surface of the substrate and is patterned so that contacting portions forming electrodes for enabling current flow through the resistor 34 are formed. (Fig. 4G). Fig. 7 is a plan view of the shape of the resist mask 36 in which the contacting portions are opened as shown in Fig. 4G.

By etching the oxide film 30 with buffer hydrofluoric acid solution (BHF of 6:1) using the resist mask 36 as shown in Fig. 4H, the oxide film 30 in the contacting portions is removed and a part of the ion implantation portions 34 can be exposed. Fig. 8 is a plan view showing the state in which the oxide film 30 of the contact portions is removed.

In Fig. 4I, the resist mask 36 is removed, and aluminium pads 30 for lead electrode leading wires are patterned to expose the ion implantation portions 34 on the contact as shown in Fig. 4J.

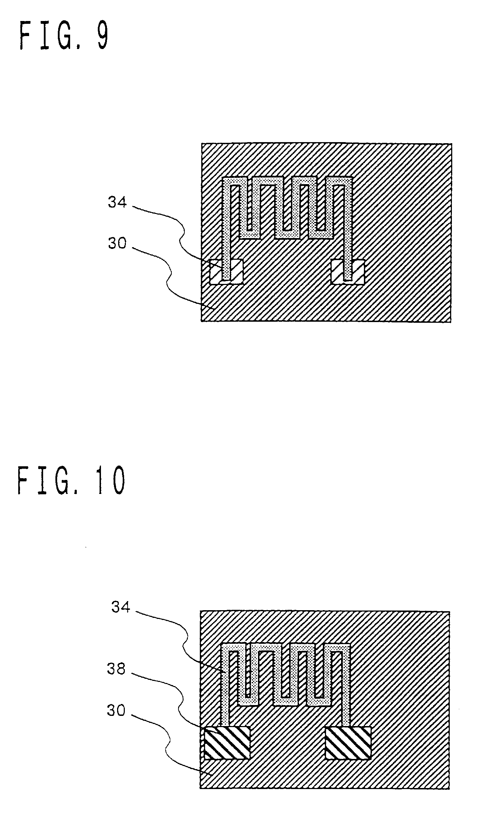

In the patterning process of the aluminium pads 38, aluminium film is formed with a thickness of about 1 µm on the substrate, a resist film is coated on it, and the resist mask is patterned. By etching the aluminium using the resist mask for an etching mask and by removing the resist mask, the aluminium pads as shown in Fig. 4J can be formed. Fig. 10 is a plan view showing the state in which the aluminium pads 38 are formed on the contacting portions in Fig. 4J.

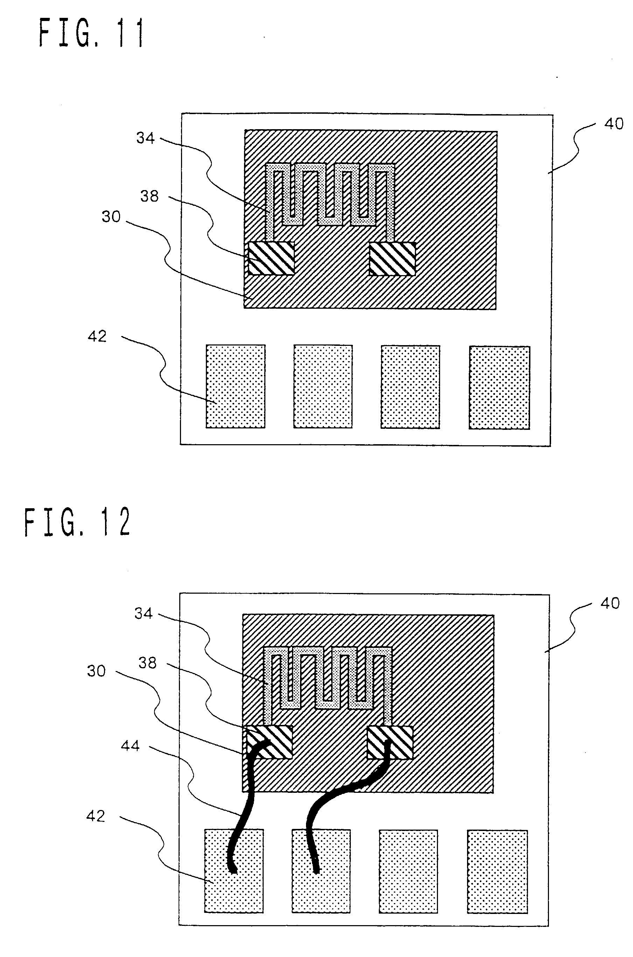

In Fig. 4K, the correlation sample formed in Fig. 4J and which enables local heating is fixed on a board for bonding 40. Fig. 11 shows a plan view of Fig. 4K. As shown in Fig. 11, electrodes 42 supplying current for heating to the correlation sample are located on the board for bonding.

In Fig. 4L, the aluminium pads 38 of the correlation sample fixed on the board for bonding 40 in Fig. 4K and electrode 42 (shown in Fig. 12) on the board for bonding 40 are connected by bonding with wires 44 such as gold wire. Fig. 12 shows a plan view of Fig. 4L.

Thus, the correlation sample shown in Fig. 12 can generate a calorie output depending on the quantity of current supplied from electrodes 42 to flow to resistor 34 in the silicon substrate 10 through the wires 44 and the aluminium pads 38.

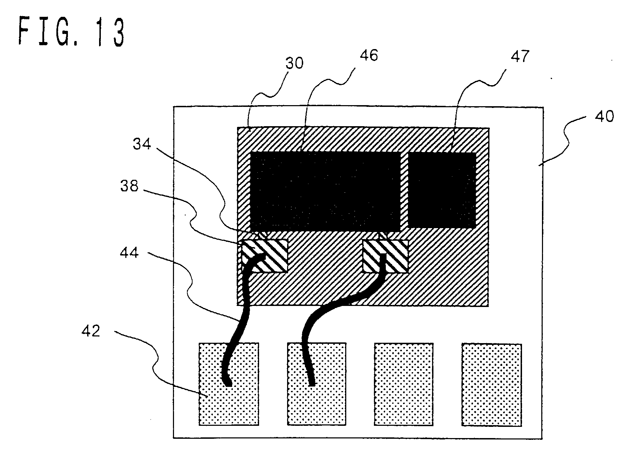

Fig. 13 shows an example in which a heat sink metal pad 46 is formed on the resistor 34 formed by implanting ions into the silicon substrate. The heat sink metal pad 46 increases the heat efficiency generated by the resistor 34. A heat sink metal pad 47 is formed at a domain where the resistor 34 is not formed. The heat sink metal pad 47 is formed in order that the heated state and un-heated state can be compared correctly by constituting a heating domain and a non-heating domain in the surface of the correlation sample with the same condition (material).

As the above-mentioned heat sink metal pads 46 and 47 can be formed with the same thickness using the same aluminium film (the aluminium pads 38 described in Fig. 4J and Fig. 10), the pads can be made in parallel with the process of the aluminium pads 38.

Thus, the fourth embodiment can make a correlation sample which enables heating of the sample locally in order to observe the interaction of heat and image. By adjusting the quantity of current flowing to the resistor formed in the substrate, the desired quantity of calorie can be controlled. The resistance of the resistor can be changed so as to change the quantity of calorie by changing the impurity ion concentration implanted in the substrate when forming the resistor. Temperature increase of the correlation sample is possible at up to several hundred °C.

Although the above-mentioned fourth embodiment provides a correlation sample for observing the heating state of the sample itself, the sample can be used as a very compact heating holder by installing another sample on the correlation sample to enable local heating.

According to the first and second aspects of the present invention, detecting each force acting as a standard can be carried out purely and correctly so as to carry out absolute measurements with various kinds of scanning probe microscope without any influence from irregularity of data of the sample.

According to the third and fourth aspects of the present invention, absolute measurements can be carried out correctly as plural height standards and width standards formed on the same sample.

According to the fifth and sixth aspects of the present invention, a physical constant and at least one of the height standard and width standard acting as a standard are formed on one sample, and therefore these can be provided at the same time.

According to the seventh and eighth aspects of the present invention, the surface of the sample does not receive any influence due to different friction forces and is protected from oxidation, corrosion, charging up of the surface of the sample, adhesion of contaminants by charging up, flaws in the surface and asymmetric wear by the probe, so as to keep flatness; by coating a film on the surface of the sample.

According to the ninth and tenth aspects of the present invention, a correlation sample enabling control of the quantity of calorie and enabling local heating in order to observe the interaction of heat and image is obtained.

## Claims

1. A correlation sample for a scanning probe microscope for measuring a state of a surface of a sample, comprising a foreign domain where material having a physical constant different from the material of a substrate is buried with a certain thickness in the in-plane direction of the substrate acting as a sample, wherein the surface of said substrate is flat.

2. A method of processing a correlation sample for a scanning probe microscope for measuring a state of a surface of a sample comprising the steps of:
forming holes of a certain depth having a vertical wall face to the surface of a substrate at a predetermined domain of the substrate acting as a sample;
burying material having a physical constant different from the material of said substrate into the holes; and
flattening the surface of the domain where the material differing in said physical constant is buried and the surface of said substrate.

3. A correlation sample for a scanning probe microscope for measuring a state of a surface of a sample, comprising at least one of domains having plural different height standards in height and plural different width standards in width formed in the in-plane direction of the substrate acting as a sample.

4. A method of processing a correlation sample for a scanning probe microscope for measuring a state of a surface of a sample comprising the steps of:
forming at least one of first domains of a first height standard and a first width standard at a predetermined position of a substrate acting as a sample; and
forming at least one of second domains of a second height standard and a second width standard at a position of the substrate different from the first said domain.

5. A correlation sample for a scanning probe microscope for measuring a state of a surface of a sample, comprising:
a foreign domain where material having a physical constant different from the material of a substrate is buried with a certain thickness in the in-plane direction of the substrate as a sample; and
at least one domain of height standard and width standard formed at a position of the substrate different from said foreign domain.

6. A method of processing a correlation sample for a scanning probe microscope for measuring a state of a surface of a sample comprising the steps of:
forming holes of certain depth having a vertical wall face to the surface of a substrate at a predetermined domain of the substrate acting as a sample;
forming at least one hole of height standard and width standard at a position of the substrate different from the previously mentioned holes;
selectively burying material having a physical constant different from the material of said substrate into the holes having said vertical wall face; and
flattening the surface of the domain where the material different in said physical constant is buried and the surface of said substrate.

7. A correlation sample for a scanning probe microscope according to any of claim 1 and claim 5,
wherein a coating film having surface wear and abrasion resistance is formed on the surface of said formed correlation sample.

8. A method of processing a correlation sample for a scanning probe microscope according to any of claim 2 and claim 6, further comprising the step of forming a coating film having surface wear and abrasion resistance on the surface of said formed correlation sample.

9. A correlation sample for a scanning probe microscope comprising:
an electric resistor formed in a substrate at a certain section of the surface of the substrate acting as a sample; and
electrodes connected with said electric resistor at said surface of the substrate for enabling current flow to the electric resistor.

10. A method of processing a correlation sample for a scanning probe microscope comprising the steps of:
forming an electric resistor by covering expect in a certain section a surface of a substrate which includes a semiconductor, with an ion implantation mask and by implanting impurity ions into a certain domain in the substrate; and
forming an electrode material on at least two connecting portions connected with said electric resistor on said surface of said substrate.
